# EUROPÄISCHE PATENTSCHRIFT

(11) **EP 0 648 374 B1**
(45) Veröffentlichungstag und Bekanntmachung des Hinweises auf die Patenterteilung: **05.09.2001**
(21) Anmeldenummer: 93912620.7
(22) Anmeldetag: 24.06.1993
(51) Int. Cl.: H01L 21/82

(54) **PLANARISIERUNGVERFAHREN FÜR INTEGRIERTE HALBLEITERSCHALTUNGEN**
PLANARISING PROCESS FOR INTEGRATED SEMICONDUCTOR CIRCUITS
PROCEDE PLANAR POUR CIRCUITS INTEGRES A SEMI-CONDUCTEURS

(30) Priorität: 30.06.1992 DE 4221432
(43) Veröffentlichungstag der Anmeldung: 19.04.1995
(73) Patentinhaber: Infineon Technologies AG, 81669 München (DE)
(72) Erfinder: AUER, Stefan, D-85221 Dachau (DE); KOHLHASE, Armin, D-85579 Neubiberg (DE); MELZNER, Hanno, D-82008 Unterhaching (DE)
(74) Vertreter: Zedlitz, Peter, Dipl.-Inf.
(86) Internationale Anmeldenummer: DE9300553
(87) Internationale Veröffentlichungsnummer: WO9400876

(56) Entgegenhaltungen:
- EP-A- 0 224 646
- US-A- 5 064 683
- PATENT ABSTRACTS OF JAPAN vol. 16, no. 303 (E-1228) 3. Juli 1992 & JP,A,4 082 263 (SHARP CORP) 16 March 1992
- PATENT ABSTRACTS OF JAPAN vol. 15, no. 323 (E-110) 16. August 1991 & JP,A,3 120 864 (TOSHIBA CORP) 23 May 1991
- PATENT ABSTRACTS OF JAPAN vol. 15, no. 448 (E-1133) 14. November 1991 & JP,A,3 190 161 (FUJITSU LTD) 20 August 1991
- PATENT ABSTRACTS OF JAPAN vol. 15, no. 405 (E-1122) 16. Oktober 1991 & JP,A,3 165 557 (MITSUBISHI ELECTRIC CORP) 17 July 1991

## Beschreibung

Die Erfindung betrifft ein globales Planarisierungsverfanren für integrierte Halbleiterschaltungen oder mikromechaniscne Bauteile mit großflächigen Gebieten verschiedener Höhen und einer zu planarisierenden Stufe zwischen einem hönerliegenden und einem niedrigerliegenden Gebiet, sowie eine entsprechende Anordnung.

In der Halbleitertechnologie und in der Mikromechanik (einschließlich Sensorik) ist das Problem bekannt, daß im Laufe der Herstellung der Bauteile Gebiete mit verschiedenen Höhen gebildet werden, die relativ großfläcnig (>1000 µm²) sind, wobei die zwischen den Gebieten bestehende Stufe planarisiert werden soll.

Ein Beispiel dafür sind integrierte Halbleiterschaltungen, bei denen die einzelnen Schaltungselemente wie Transistoren und Kondensatoren nach ihrer Herstellung niederohmig miteinander verbunden werden müssen. Dies geschieht im allgemeinen mit Hilfe ein- oder mehrlagiger Metallisierungsstrukturen, die durch ganzflächige Abscheidung einer Metallschicht mit anschließender fototechnischer Strukturierung zu Leitbahnen hergestellt werden. Für eine elektriscn zuverlässige Metallisierungsstruktur ist es erforderlich, daß der Untergrund vor Abscheidung der Metallschicht eine möglichst große Planarität aufweist, d.h. keine scharfen Kanten besitzt und der Höhenunterschied innerhalb der Focustiefe der verwendeten Fototechnik liegt.

Besonders die zweite Bedingung ist bei zunenmender Integrationsdichte der Schaltung oft schwer einzuhalten, da eine laterale Verkleinerung in vielen Fällen einen Zuwachs in der vertikalen Dimension erfordert. So werden bei DRAM-Halbleiterspeichern zur Erhöhung der Integrationsdichte Speicherzellen vom Typ "stacked-capacitor" oder "stacked-capacitor-above-bitline" eingesetzt, wie sie z.B. in dem Artikel von T. Kaga in IEEE Transactions on ED Volume 38, Nr. 2, Februar 1991, Seite 255 beschreiben sind, bei denen der aufgesetzte Kondensator eine Stufe zwischen relativ großflächigen (Größenordnung 100 µm x 100 µm) Gebieten, nämlich dem Zellenfeld und der die Beschaltung enthaltenden niedrigerliegenden Peripherie verursacht. Eine derartige Stufe kann mit üblichen, lokalen Planarisierungsverfahren nicht ausgeglichen werden. Eine besonders hohe Stufe tritt auf, wenn zur Kapazitätserhöhung ein sogenannter Schüssel- oder Crown-Kondensator eingesetzt wird.

Die erwähnte Metallschicht muß verschiedene leitende Strukturen, die in verschiedenen Ebenen angeordnet sind (z. B. Substrat, Wortleitungsebene, Bitleitungsebene, Kondensator), kontaktieren, indem Kontaktlöcher in eine die Metallisierungsstruktur und die leitenden Strukturen trennende Isolationsschicht geätzt werden und diese mit einem leitenden Material aufgefüllt werden. Es ist vorteilhaft, wenn die dabei zu durchätzenden Schichtdicken der Isolationsschicht genau bekannt sind, um längere Überätzzeiten zu vermeiden und sogenannte "non-nested-contacts" zu ermöglichen.

Es stellt sich daher das Problem, ein hierfür geeignetes globales Planarisierungsverfahren anzugeben.

Grundsätzlich sind zur globalen Planarisierung Schleifverfahren (sogenanntes Chemical mechanical polishing, CMP) bekannt. CMP kann bei verschiedenen Materialien eingesetzt werden und ist in dem Artikel W.J. Patrick et al., J. Electrochem. Soc. Volume 138, Nr. 6, Juni 1991, Seite 1778 näher beschrieben. Es wird bisher jedoch vorzugsweise bei der Mehrlagenverdrahtung von integrierten Schaltungen angewandt (siehe z.B. C. Kanta et al., VMIC Conference 1991, Seite 144). CMP ermöglicht eine globale, d.h. langreichweitige Planarisierung der Oberfläche bei sehr niedrigen verbleibenden Stufen (maximal etwa 100nm). Durch geeignete Zusammensetzung der Polierflüssigkeit kann eine Selektivität zwischen verschiedenen Materialien erzielt werden. Ein sinnvoller Einsatz eines CMP-Schrittes setzt andererseits in vielen Fällen voraus, daß die Oberfläche bereits vor dem Prozeß hinreichend gut planarisiert ist. Andernfalls würden hochliegende Strukturen beschädigt, während über tiefliegenden noch unerwünschte Reste verblieben.

In der EP-A 224 646 ist ein Verfahren zur Entfernung einer Erhöhung in Form eines Steges, der aus einer ersten Schicht im Randbereich eines höherliegenden Gebietes auf einer Substratoberfläche gebildet ist, mittels CMP beschrieben. Dazu wird ganzflächig eine Polierstopschicht als zweite Schicht aufgebracht; dann wird ein Schleifverfahren durchgeführt, bei dem die Polierstopschicht lediglich auf dem Steg und der Steg selbst entfernt werden. Auf einem tieferliegenden Gebiet verbleiben die Polierstopschicht und die erste Schicht. Es wird keine globale Planarisierung erreicht, da die Polierstopschicht auf großflächigen Gebieten nicht abgetragen wird und die vollständige Einebnung verhindert. Darüber hinaus besteht die Gefahr einer schlechten lokalen Planarisierung: Sobald die Polierstopschicht auf dem Steg entfernt ist, wird die unterliegende Schicht mit hoher Abtragrate entfernt. Eine verlängerte Polierzeit (zum Ausgleich einer meist schlechten Gleichmäßigkeit des Abtrags über einem gesamten Wafer) führt daher zwangsläufig zu einer schlechten lokalen Planarisierung.

Aufgabe der Erfindung ist es, ein verbessertes globales Planarisierungsverfahren für ein mikromechanisches Bauteil oder eine integrierte Halbleiterschaltung, insbesondere für einen Halbleiterspeicher mit stacked-capacitor-above-bitline-Zellen, anzugeben, mit dem Stufen zwischen großflächigen Gebieten eingeebnet werden können. Es soll besonders einfach durchführbar sein und auch bei hohen zu planarisierenden Stufen einsetzbar sein.

Diese Aufgabe wird durch ein Verfahren gemäß Patentanspruch 1 gelöst. Weiterbildungen sind Gegenstand von Unteransprüchen.

Die Erfindung beruht auf einer speziellen Kombination von CMP mit einem Abscheide-, Fototechnik- und Ätzprozeß und ist bei mikromechanischen Bauteilen und bei integrierten Schaltungen (bspw. der eingangs erläuterten Art zur globalen Planarisierung von Zellenfeld und Peripherie) anwendbar. Die Erfindung ist insbesondere einsetzbar bei Speicheranordnungen, bei denen vor Herstellung des Kondensators bereits eine global planare Oberfläche vorliegt. In den deutschen Patentanmeldungen DE-A-42 23 878 "Herstellverfahren für eine Halbleiterspeicheranordnung" und DE-A-42 21 431 "Herstellverfahren für einen Schüsselkondensator" derselben Erfinder vom 30.6.1992, auf deren Gesamtinhalt hier verwiesen wird, sind entsprechende Speicheranordnungen offenbart.

Die Erfindung wird nachfolgend anhand eines in den Zeichnungen dargestellten Ausführungsbeispiels näher beschrieben. Es zeigen:
- Figur 1:: einen Querschnitt durch eine Speicherzelle und durch einen Ausschnitt der Peripherie nach Durchführung des erfindungsgemäßen Verfahrens
- Figuren 2 bis 4:: einen ausschnittsweisen Querschnitt durch das Halbleitersubstrat am Rand des Zellenfeldes, an dem die Verfahrensschritte einer Ausführungsform der Erfindung verdeutlicht werden.

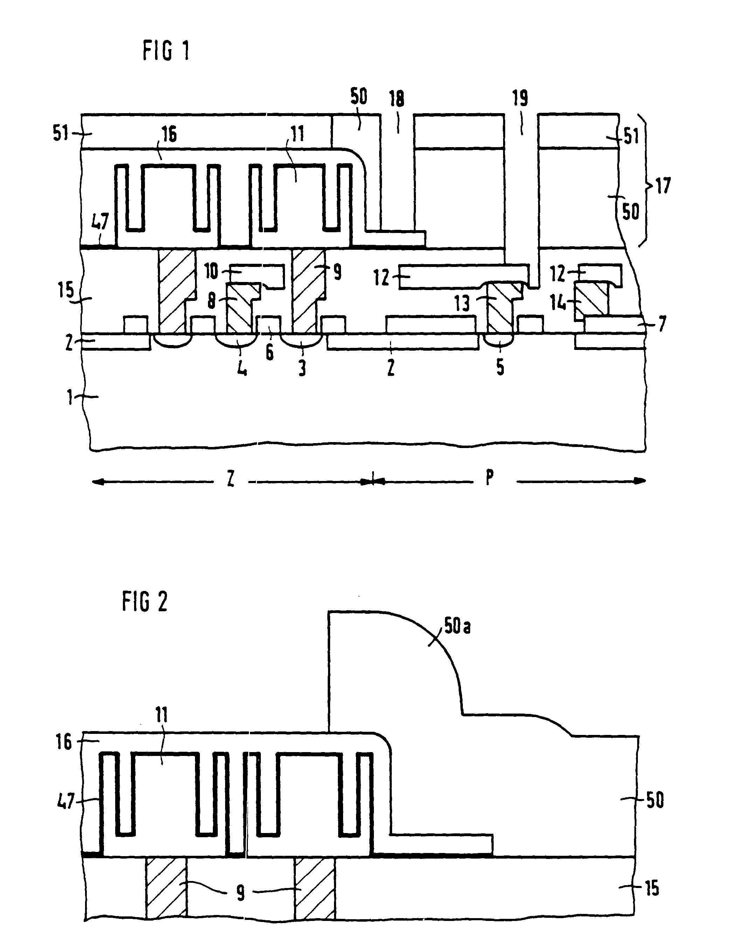

Figur 1: Als Beispiel für ein erfindungsgemäß planarisiertes Bauteil ist eine Halbleiterschaltung (DRAM-Speicheranordnung) dargestellt, und zwar ein Querschnitt durch zwei benachbarte Speicherzellen am Rand eines Zellenfeldes parallel zum aktiven Gebiet und durch eine typische Peripherieschaltung, wobei die Speicheranordnung bis auf die Herstellung von Verdrahtungsebenen fertiggestellt ist. In einem Halbleitersubstrat 1 sind Isolationsgebiete 2 angeordnet, die verschiedene Speicherzellen voneinander isolieren. Das Halbleitersubstrat 1 enthält ferner dotierte Gebiete 3, 4, 5 als Source 3 oder Drain 4 von Transistoren im Zellenfeld oder in der Peripherie oder als Anschluß (5) des Halbleitersubstrats 1. Auf der Substratoberfläche (bzw. auf einem nicht dargestellten Gateoxid) befinden sich in einer Wortleitungsebene ein Gate 6 des Transistors und andere leitende Strukturen 7. Ein Transistor-Bitleitungs-Pfeiler 8 (TB-Pfeiler) verbindet das Draingebiet des Transistors mit einer überliegenden Bitleitung 10, ein Transistor-Kondensator-Pfeiler 9 (TK-Pfeiler) verbindet das Sourcegebiet 3 mit einer unteren Kondensatorplatte 11. In der Peripherie sind weitere Pfeiler vorgesehen, die in der Bitleitungsebene liegende Leitbahnen 12 mit dem dotierten Substratgebiet 5 (SB-Pfeiler 13) oder mit der leitenden Struktur 7 in der Wortleitung-Ebene (WB-Pfeiler 14) verbinden. Die Pfeiler 8, 9, 13, 14, Bitleitung 10 und Leitbahnen 12 sind in einer ersten isolierenden Schicht 15 angeordnet. Es ist vorteilhaft, wenn die erste isolierende Schicht 15 eine global planarisierte Oberfläche besitzt, die auf gleicher Höhe wie die Oberkante der TK-Pfeiler 9 liegt.
Der Kondensator besteht aus der unteren, vorzugsweise als Schüssel ausgebildeten Kondensatorplatte 11 und einer allen Speicherzellen gemeinsamen Gegenplatte 16, die durch ein Dielektrikum 47 von der unteren Kondensatorplatte isoliert wird. Wie in der Figur erkennbar ist, stellt das Zellenfeld das höherliegende und die Peripherie das niedrigerliegende Gebiet dar.

Eine zweite isolierende Schicht 17 bedeckt die Gegenplatte 16 im Zellenfeld bzw. die erste isolierende Schicht 15 in der Peripherie. In ihr sind Vias 18, 19 angeordnet, über die die Gegenplatte 16 oder die Leitbahn 12 der Bitleitungs-Ebene (und damit das Halbleitersubstrat oder die Wortleitungs-Ebene) angeschlossen werden können. Erfindungsgemäß weist die zweite isolierende Schicht 17 eine global planarisierte Oberfläche auf. Die zweite isolierende Schicht ist aus zwei Teilschichten, einem ersten Dielektrikum 50 als erste Schicht und einem zweiten Dielektrikum 51 als zweite Schicht aufgebaut.

Der Einsatz des erfindungsgemäßen Verfahrens ist besonders vorteilhaft bei Speicneranordnungen, wie sie in den bereits genannten deutschen Patentanmeldungen derselben Erfinder beschrieben sind: Die bei der Ätzung der Vias 18 bzw. 19 freizulegenden Strukturen (16 bzw. 12) sind auf global planarisierten Oberflächen angeordnet, so daß die zu durchätzenden Schichtdicken genau definiert sind; zusätzlich liegt die Gegenplatte 16 in einem Randstreifen rund um das Zellenfeld nicht viel höher als die Leitbahnen 12, so daß die Überätzung auf der Gegenplatte gering ist. Es wird dadurch vermieden, daß die Gegenplatte 16 bei der Ätzung der Vias durchgeätzt wird. Eine geeignete ein- oder mehrlagige Metallisierungsstruktur (nicht dargestellt) dient anschließend zur niederohmigen Verdrahtung der Schaltelemente über die Vias 18, 19.

Figur 2: Nach der Herstellung der Gegenplatte 16 mit bekannten Verfahren wird erfindungsgemäß eine erste Schicht 50. z. B. ein Siliziumoxid, abgeschieden, dessen Dicke genau gleich der zu planarisierenden Stufen zwischen dem Zellenfeld als höherliegendem Gebeit und der Peripherie als niedrigerliegendem Gebiet ist. In diesem Fall ist die abzuscheidende Schichtdicke also gleich der Höhe der Kondensatoren (einschließlich der Gegenplatte) 11, 47, 16. In der Praxis kann dies dadurch erreicht werden, daß die Höhe der Kondensatoren vor der Abscheidung mittels Profilometrie gemessen wird und die Schichtdicke auf diesen Wert eingestellt wird. Anschließend wird das erste Dielektrikum 50 mittels einer Fototechnik in einem geeigneten Ätzprozeß im Zellenfeld wieder vollständig entfernt, wobei am Rand des Zellenfeldes ein Steg 50a verbleibt. Dabei wird ein zum Material der Gegenelektrode, meist Polysilizium, selektiver Ätzprozeß eingesetzt. Abgesehen von diesem Steg 50a ist die Oberfläche nun bereits global planar. Die Breite des Stegs 50a hängt im wesentlichen von der erreicnbaren Justiergenauigkeit der verwendeten Fototechnik ab und liegt in der Größenordnung 1 Mikrometer.

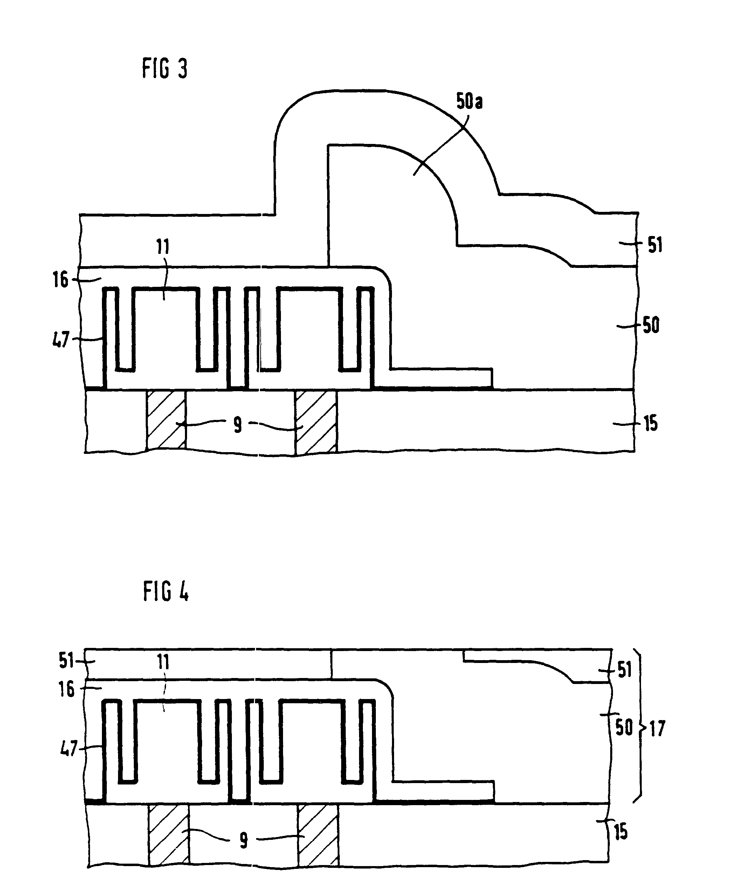

Figur 3: Erfindungsgemäß wird nun ein zweites Dielektrikum 51 von etwa 500 nm Dicke abgeschieden, das aus demselben Material wie das erste Dielektrikum 50 bestent.

Figur 4: Ein Teil der Dicke dieses zweiten Dielektrikums 51, beispielsweise 200 nm, wird in einem CMP-Schritt abgetragen. Über den Stegen 50a wird es vollständig entfernt, gleichzeitig wird der Steg mit eingeebnet. Nun liegt also eine global planarisierte Oberfläche der Halbleiterspeicheranordnung vor. Das abgeschliffene erste und zweite Dielektrikum 50, 51 bilden die Teilschichten der zweiten isolierenden Schicht 17, in die anschließend die Vias 18, 19 geätzt werden können.

Die Gleichmäßigkeit des Abtrags in dem CMP-Schritt über eine gesamte, mehrere Speicheranordnungen enthaltende Halbleiterscheibe ist meist nicht besonders gut. Die Erfindung sieht deshalb einen Planarisierungsprozeß vor, bei dem ein möglichst geringer Abtrag im CMP-Schritt erforderlich ist. Da die Stege 50a schmal sind und einen großen gegenseitigen Abstand aufweisen, werden sie in dem CMP-Schritt mit hoher Abtragsrate entfernt. Ein besonderer Vorteil des erfinderischen Verfahrens ist, daß die Gleichmäßigkeit bei der Ätzung des ersten Dielektrikums 50, die u. U. ebenfalls schlecht ist, keinen Einfluß auf die später vorliegenden Schichtdicken hat, da bei der Ätzung auf der Gegenplatte 48 gestoppt wird. Im wesentlichen ist die Schichtdicke außerhalb des Zellenfeldes als durch weitgehend präzise definierte Abscheidungen gegeben. Dies ist besonders vorteilhaft, da dadurch in der Peripherie sogenannte "Non-Nested" Kontaktlöcher zu den Leitbahnen in der Bitleitungsebene hergestellt werden können (siehe Figur 1, Kontaktloch 19), d.h. die Kontaktlöcher 19 können über die Kante der Leitbann 12 hinausreichen, so daß der Platzbedarf der Schaltung stark verringert wird. Bei Non-Nested-Vias kann das Problem auftreten, daß die Kontaktlochätzung an der Leitbahn vorbei bis zu unterliegenden Leitbannebenen reicht und damit Kurzschlüsse zwischen der Kontaktlocnauffüllung und diesen tieferen Leitbahnen entstehen. Die Ätzung der Kontaktlöcher 19 muß deshalb früh genug abgebrochen werden, bevor tiefere Leitbahnen erreicht werden. Andererseits muß natürlich jedes Kontaktloch 19 bis zur Leitbann 12 reichen. Es ist also erforderlich, daß die Schichtdicke des gesamten Dielektrikums über der Leitbann 12 genau bekannt und über die Halbleiterscheibe ausreichend gleichmäßig ist. Dies wird durch die erfindungsgemäße globale Planarisierung in hohem Maße gewährleistet.

Je nach den gegebenen Anforderungen, insbesondere bei mikromechanischen Bauteilen ohne direkten elektrischen Anschluß, können die erste und zweite Schicht 50, 51 auch aus einem anderen als einem dielektrischen Material bestehen.

## Patentansprüche

1. Globales Planarisierungsverfahren für integrierte Halbleiterschaltungen oder mikromechanische Bauteile mit großflächigen Gebieten verschiedener Höhen und einer zu planarisierenden Stufe zwischen einem höherliegenden und einem niedrigerliegendem Gebiet, bei dem eine erste Schicht aufgebracht und strukturiert wird, bei dem anschließend eine zweite Schicht aufgebracht und danach ein Schleifverfahren durchgeführt wird,
**gekennzeichnet** durch folgende Verfahrensschritte:
- Bestimmen der Höhe der Stufe mittels einer Messung,
- ganzflächiges Aufbringen der ersten Schicht in einer Dicke, die der gemessenen Höhe der Stufe entspricht,
- Entfernen der ersten Schicht im höherliegenden Gebiet mit Hilfe einer Fototechnik, wobei nur in einem Randbereich des höherliegenden Gebiets die erste Schicht als Steg verbleibt,
- ganzflächiges Aufbringen einer zweiten Schicht aus dem Material der ersten Schicht
- Einebnen der gesamten, dem höherliegenden und dem niedrigerliegenden Gebiet zugeordneten Oberfläche mit Hilfe eine Schleifverfahrens, in dem auf dem Steg die gesamte zweite Schicht entfernt wird und im übrigen höherliegenden und niedrigerliegenden Gebiet ein Teil der zweiten Schicht entfernt wird.

2. Globales Planarisierungsverfahren nach Anspruch 1,
**dadurch gekennzeichnet,**
- daß als integrierte Halbleiterschaltung eine Halbleiterspeicheranordnung mit Ein-Transistor-Speicherzellen verwendet wird,
- daß als niedrigerliegendes Gebiet eine eine Beschaltung enthaltende Peripherie (P) verwendet wird,
- daß als höherliegendes Gebiet ein die Speicherzellen enthaltendes Zellenfeld (Z)verwendet wird, wobei die Speicherzellen eine oberhalb des Transistors angeordnete Bitleitung (10) und einen oberhalb der Bitleitung angeordneten Kondensator (11, 47, 16) aufweisen, und die Kondensatoren auf einer das Zellenfeld (Z) und die Peripherie (P) bedeckenden, global planarisierten ersten isolierenden Schicht (15) angeordnet sind,
- daß als erste Schicht (50) und als zweite Schicht (51) ein Dielektrikum verwendet wird, und
- daß die erste Schicht (50) in einer Dicke abgeschieden wird, die der Höhe der Kondensatoren (11, 47, 16) entspricht.

3. Globales Planarisierungsverfahren nach einem der Ansprüche 1 oder 2,
**dadurch gekennzeichnet,**
daß zur Entfernung der ersten Schicht (50) ein zum Material des unterliegenden Gebiets selektiver Ätzprozeß eingesetzt wird.

4. Globales Planarisierungsverfahren nach einem der Ansprüche 2 bis 3,
**dadurch gekennzeichnet,**
daß vor Herstellung der Kondensatoren (11, 47, 16) die erste isolierende Schicht (15) mit Hilfe eines CMP-Schritts global planarisiert wird.

## Claims

1. Global planarization process for integrated semiconductor circuits or micromechanical components having large-area regions of various heights and a step to be planarized between a higher-lying region and a lower-lying region, in which process a first layer is applied and structured, in which process a second layer is subsequently applied and then a polishing process is carried out,
characterized by the following process steps:
- determining the height of the step by means of a measurement,
- applying the first layer over the entire surface in a thickness which corresponds to the measured height of the step,
- removal of the first layer in the higher-lying region with the aid of a photolithographic procedure, the first layer remaining only in a border area of the higher-lying region as a rib,
- applying a second layer of the material of the first layer over the entire surface,
- levelling of the entire surface assigned to the higher-lying region and the lower-lying region with the aid of a polishing process, in which the entire second layer on the rib is removed and part of the second layer in the remaining higher-lying region and lower-lying region is removed.

2. Global planarization process according to Claim 1, characterized
- in that a semiconductor memory arrangement with one-transistor memory cells is used as the integrated semiconductor circuit,
- in that a periphery (P) containing a wiring is used as the lower-lying region,
- in that a cell array (Z) containing the memory cells is used as the higher-lying region, the memory cells having a bitline (10) arranged above the transistor and a capacitor (11, 47, 16) arranged above the bitline, and the capacitors being arranged on a globally planarized first isolating layer (15), covering the cell array (Z) and the periphery (P),
- in that a dielectric is used as the first layer (50) and as the second layer (51), and
- in that the first layer (50) is deposited in a thickness which corresponds to the height of the capacitors (11, 47, 16).

3. Global planarization process according to one of Claims 1 or 2, **characterized in that** an etching process selective with respect to the material of the underlying region is used for removing the first layer (50).

4. Global planarization process according to one of Claims 2 or 3, **characterized in that**, before production of the capacitors (11, 47, 16), the first isolating layer (15) is globally planarized with the aid of a CMP step.

## Revendications

1. Procédé global de planarisation pour des circuits intégrés à semi-conducteurs ou des composants micromécaniques ayant des domaines de grandes surfaces de niveaux différents et un gradin à planariser entre un domaine de niveau haut et un domaine de niveau bas, dans lequel on dépose et on structure une première couche, dans lequel on dépose ensuite une deuxième couche et dans lequel on effectue ensuite un procédé de polissage,
caractérisé par les stades suivants de procédé:
- détermination de la hauteur du gradin au moyen d'une mesure,
- dépôt sur toute la surface de la première couche en une épaisseur qui correspond à la hauteur du gradin qui a été mesurée,
- élimination de la première couche dans le domaine de niveau le plus haut à l'aide d'une technique photographique en ne laissant subsister la première couche sous la forme d'une nervure que dans une région marginale du domaine de haut niveau,
- dépôt sur toute la surface d'une deuxième couche en la matière de la première couche,
- aplanissement de toute la surface associée au domaine de niveau haut et au domaine de niveau bas à l'aide d'un procédé de polissage, dans lequel on élimine sur la nervure toute la deuxième couche et on élimine en outre dans le domaine de niveau haut et le domaine de niveau bas une partie de la deuxième couche.

2. Procédé global de planarisation suivant la revendication 1,
caractérisé
- en ce que l'on utilise comme circuit intégré à semi-conducteurs un dispositif de mémoire à semi-conducteurs ayant des cellules de mémoire à un seul transistor,
- en ce que l'on utilise comme domaine de niveau bas une périphérie (P) contenant un câblage,
- en ce que l'on utilise comme domaine de niveau haut un champ (Z) de cellules contenant les cellules de mémoire, les cellules de mémoire comportant un conducteur (10) de bits disposé au-dessus du transistor et un condensateur (11, 47, 16) disposé au-dessus du conducteur de bits et les condensateurs étant disposés sur une première couche (15) isolante recouvrant le champ (Z) de cellules et la périphérie (P) et planarisée globalement,
- en ce que l'on utilise comme première couche (50) et comme deuxième couche (51) un diélectrique et
- en ce que l'on dépose la première couche (50) en une épaisseur qui correspond à la hauteur des condensateurs (11, 47, 16).

3. Procédé global de planarisation suivant l'une des revendications 1 ou 2, caractérisé
en ce que l'on utilise pour éliminer la première couche (50) une opération d'attaque chimique sélective vis à vis de la matière du domaine sous-jacent.

4. Procédé global de planarisation suivant l'une des revendications 2 à 3, caractérisé
en ce qu'avant la fabrication des condensateurs (11, 47, 16) on planarise la première couche (15) isolante globalement à l'aide d'un stade de CMP.
